# EUROPEAN PATENT APPLICATION

(11) **EP 4 175 319 A1**
(43) Date of publication of application: **03.05.2023**
(21) Application number: 21205567.7
(22) Date of filing: 29.10.2021
(51) Int. Cl.: H04R 3/00, H04R 7/10, H04R 17/02, H04R 19/00, H04R 19/04

(54) **MICRO-ELECTROMECHANICAL UNIT, LOUDSPEAKER AND MICROPHONE THEREOF**

(71) Applicant: Epinovatech AB, 223 63 Lund (SE)
(72) Inventor: OLSSON, Martin Andreas, 223 63 Lund (SE)
(74) Representative: AWA Sweden AB

(57) **Abstract**

A micro-electromechanical unit (100) is provided. The micro-electromechanical unit (100) comprises a diaphragm (10) having a planar extension. The diaphragm (10) comprises a semiconductor structure (20) comprising a first (22) and a second (24) layer, each layer extending in the planar extension. The first layer (22) comprises AI(1-x)Ga(x)N, wherein 0.2 ≤ x ≤ 0.4, and the second layer (24) comprises GaN. The micro-electromechanical unit (214) further comprises a support structure (30) supporting the diaphragm (10), and an electrode arranged (50) on a surface of the diaphragm (10). Also, a loudspeaker device (200) and a microphone device (300) comprising the micro-electromechanical unit (100) are disclosed.

## Description

### TECHNICAL FIELD

The present disclosure relates to micro-electromechanical units, and loudspeakers and microphones thereof.

### BACKGROUND

An audio device, such as an amplifier connected to a loudspeaker or a microphone, is associated with many physical properties, such as an on-resistance, a signal-to-noise ratio, SNR, consumption of electrical power/energy. These physical properties often include a compromise between high fidelity audio quality and the physical dimension of the audio device. With the presently rapid transition of consuming sound through ever smaller wireless earbuds pushes this compromise further, especially since wireless earbuds have a built-in battery to supply power to a plurality of loudspeakers, microphones, and relatively power draining wireless communication means. Hence, there is an ongoing need to reduce the on-resistance and increase the SNR, while at the same time keeping the dimensions of the audio device minimal as well as minimizing the power demand of the same.

### SUMMARY

It is an object to mitigate, alleviate or eliminate one or more of the above-identified deficiencies in the art and disadvantages singly or in any combination and at least partly solve the above-mentioned problem.

According to a first aspect, there is provided micro-electromechanical unit. The micro-electromechanical unit comprising: a diaphragm having a planar extension, the diaphragm comprising a semiconductor structure comprising a first and a second layer, each layer extending in the planar extension, wherein the first layer comprises AI(1-x)Ga(x)N, wherein 0.2 ≤ x ≤ 0.4, and the second layer comprises GaN; a support structure supporting the diaphragm; and an electrode connected to the diaphragm. Preferably, the electrode is arranged on a surface of the diaphragm.

Elemental materials are referred to herein by their element symbol or abbreviation. For example, gallium nitride may typically be referred to as GaN and aluminium gallium nitride may be referred to as AIGaN. In general, layers or structures said to comprise a specific material or element, may be understood as at least partially comprising or substantially consisting of the specific material or element. The layers of the semiconductor structure may be understood as ordered in a bottom up order. In this context the term "on" refers to arranging layers or structures above or onto other layers or structures. The term "vertical" refers to the direction in which layers are arranged on each other. The vertical direction is considered perpendicular or normal to the top surface of the substrate, wherein the top surface may be considered to be substantially planar. The term "laterally" refers to any direction being perpendicular to the vertical direction.

The semiconductor structure is piezoelectrically actuable. Hence, a mechanical impact on the semiconductor structure may generate a voltage difference, and thereby an electrical current. Conversely, an applied voltage may cause a deformation or movement of the semiconductor structure. Hence, the diaphragm may be utilized for acoustics, such as being capable of generating or detecting pressure differences in air, i.e. sound waves. Hence, the diaphragm may function as both a loudspeaker/microphone membrane and a solenoid. Traditionally, a solenoid, which has a working principle according to Lenz law, is an external device connected to the membrane to generate/capture movements of the membrane and thereby generate/capture sound waves. Herein, such a solenoid is redundant, thereby forming an integrated device with fewer parts. The micro-electromechanical unit may reduce the need of electrical power. Other advantages may include an increased signal-to-ratio, SNR, and a reduced on-resistance. Further, this may allow for a relatively compact size.

The diaphragm may be circular in the planar extension, wherein a diameter of the diaphragm is between 1 and 800 micrometer, µm.

The semiconductor structure of the diaphragm may be a superlattice comprising GaN and AI(1-x)Ga(x)N layers, wherein 0.2 ≤ x ≤ 0.4. The superlattice may comprise a plurality of heterostructure layers, wherein each heterostructure layer comprises one GaN layer and one AI(1-x)Ga(x)N layer. The superlattice may provide a p-type two-dimensional hole gas, 2DHG, providing a channel for conduction along an interface between two layers. The superlattice facilitate generating an increased piezoelectrical effect and hence improve the signal-to-noise ratio of a speaker device according to the invention. A membrane having relatively pronounced piezoelectric properties by a superlattice may facilitate the manufacturing of piezoelectric membranes beyond using rare earth metals such as scandium in scandium-doped AIN, i.e. ScAIN or lead-based materials such as lead zirconate titanate, PZT. Standard piezoelectric thin films used for MEMS are often polycrystalline. The superlattice considered herein is preferably crystalline; hence the piezoelectric effect is not deteriorated by possible defects from polycrystalline grains. Hence, the semiconductor structure provides for a more sensitive membrane to be used for, e.g. detecting smaller deformations of the membrane.

A periodicity of the superlattice may be between 2 and 6 nm.

A thickness of the diaphragm may be between 0.1 and 5 micrometer.

The micro-electromechanical unit may further comprise a backplate having a plurality of through-holes. The density of through-holes may be 0.1-0.6 holes per micron. The backplate is elevated relative to the diaphragm by a circumferential wall. Hence, a cavity is present between the diaphragm and the backplate. The cavity may function as a pressure chamber or a resonant box. The through-holes may be through-going openings oriented perpendicular to the planar extension of the diaphragm. The plurality of through-holes may facilitate acoustical properties of the diaphragm. Further, the cavity may facilitate amplifying pressure differences originating from movements of the diaphragm. The backplate may be made in aluminium nitride by sputtering e.g. magnetron sputtering. This may provide a backplate with a low residual stress on top of the AIGaN diaphragm during manufacturing of the micro-electromechanical unit. Alternatively, the backplate may be made in silicon nitride.

The electrode may be ring shaped and arranged at an edge of the diaphragm. This facilitate generation of a voltage induced by a deformation of the diaphragm. Conversely, a specific voltage may induce a relatively large deformation of the diaphragm. Hence, this arrangement provides for a more sensitive diaphragm.

The support structure may comprise a semiconductor layer structure forming a transistor. A layer structure may be understood as a layer being arranged above another layer in the vertical direction as well as the above layer sharing a physical interface with the below adjacent layer. Such a physical interface may be configured to provide conductive contact, i.e. allowing electron and/or hole transport across the physical interface. Conductive contact may refer to, e.g. ohmic contact, Schottky contact, or contact across a pn-junction or tunnel junction. The transistor may be a high-electron-mobility transistor, HEMT. HEMTs enable higher switching frequencies and improved high power characteristics compared to conventional metal oxide semiconductor field effect transistors, MOSFETs.

The semiconductor layer structure of the support structure may comprise a silicon base layer. The silicon base layer allows a thicker GaN to be deposited/grown thereon to improve crystal quality without manufacturing complications involved by formation of the crystalline GaN/AIGaN layer structure. Other materials may be possible such as silicon carbide, SiC. However, pure silicon is preferable as of its relatively low cost.

The semiconductor layer structure of the support structure may comprise a GaN layer and a AI(1-x)Ga(x)N layer, wherein 0.2 ≤ x ≤ 0.4.

The semiconductor layer structure of the support structure may comprise an AIN layer. Such an AIN layer may be arranged above a silicon base layer and below any GaN and/or Al(1-x)Ga(x)N layers. Due to factors such as crystal lattice constants and thermal expansion coefficients being different for silicon and nitride materials, just forming a nitride layer onto a silicon layer will most often result in cracks, defects and overall poor crystal quality of the formed nitride layers due to, e.g. mismatching material properties. Hence, an AIN layer facilitate a smoother material transition between a silicon base layer and any GaN and Al(1-x)Ga(x)N layers, thereby providing an adequate electron or hole mobility through the support structure.

The micro-electromechanical unit may further comprise a calibrating weight arranged on a surface of the diaphragm. The calibrating weight may be ring-shaped, especially in the event the diaphragm is ring-shaped. The calibrating weight may be manufactured by a metal; preferably AlCu. The calibrating weight is arranged to adjust the mass of the diaphragm for tuning the acoustical properties of the diaphragm.

According to a second aspect, there is provided a loudspeaker device. The loudspeaker device comprising: a micro-electromechanical unit according to the first aspect as set out above; and circuitry configured to actuate the diaphragm of the micro-electromechanical unit.

The above-mentioned features in connection with the micro-electromechanical unit, when applicable, apply to this second aspect as well. In order to avoid undue repetition, reference is therefore made to the above. The circuitry may be comprised in a class D amplifier.

The circuitry may comprise: a driver; a comparator; and a first and a second GaN high electron mobility transistor, HEMT, connected to the driver, wherein the first and the second HEMT are electrically connected to the comparator.

The comparator may function as an ordinary comparator, e.g. an operational amplifier, by comparing an audio input signal to a high-frequency triangle wave to digitize the audio input signal. The result of the comparison is a digital copy signal from the analog audio input signal, wherein low-frequency components of the digital signal represent the audio input signal, while high-frequency signals are in general ignored. The output of the comparator drives the HEMT by an intermediately connected driver as is normal for, e.g. a class D amplifier. As set out above, the GaN HEMT transistor may provide higher switching frequencies and improved high power characteristics compared to conventional MOSFETs. Further, the electrical power demand may be reduced.

According to a third aspect, there is provided a microphone device comprising a micro-electromechanical unit according to the first aspect and circuitry configured to detect a movement of the diaphragm of the micro-electromechanical unit.

The microphone device may be a "reversed loudspeaker device". However, circuitry included in the microphone device may be of class A type since power efficiency may normally be of little concern in microphones.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### BRIEF DESCRIPTION OF THE DRAWINGS

The above and other aspects of the present invention will now be described in more detail, with reference to appended figures. The figures should not be considered limiting; instead they are used for explaining and understanding. Like reference numerals refer to like elements throughout.
Fig. 1 schematically shows a cross-sectional profile of the micro-electromechanical unit.
Figs 2A-B schematically show a cross-sectional profile of the micro-electromechanical unit exposed by a bias voltage.
Fig. 3 schematically shows a top view of a diaphragm.
Fig. 4 schematically shows an alternative geometry of a diaphragm.
Fig. 5 shows, highly schematically, a loudspeaker device.
Fig. 6 shows, highly schematically, a microphone device.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

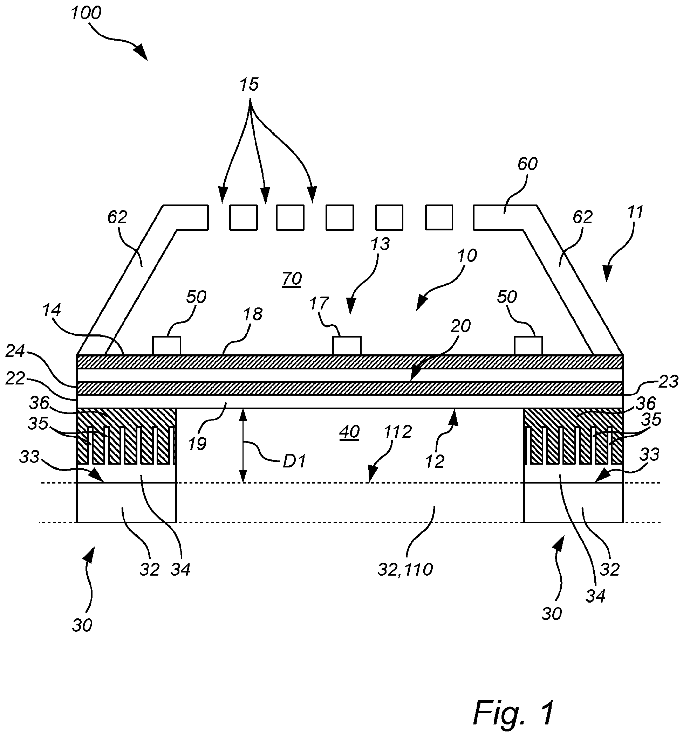

In connection with Fig. 1 there is schematically shown a cross-sectional profile of a micro-electromechanical unit 100. The micro-electromechanical unit 100 comprises a diaphragm 10. The diaphragm 10 has a planar extension. The planar extension may be an extension in a plane of a substrate 110 on which the micro-electromechanical unit 100 is attached. Hence, the planar extension and the plane of the substrate 100 may be substantially parallel. The diaphragm 100 comprises a semiconductor structure. The semiconductor structure comprises a first 22 and a second 24 layer. Notice that Fig. 1 shows, in a non-limiting way, a plurality of first and second layers. Each layer of the first 22 and the second 24 layer extends in the planar extension. The first layer 22 comprises aluminum gallium nitride, Al(1-x)Ga(x)N, wherein 0.2 ≤ x ≤ 0.4. The value of x sets the bandgap of Al(1-x)Ga(x)N. The bandgap ranges from 3.4 eV (x=1) to 6.2 eV (x=0). The second layer comprises gallium nitride, GaN. The bandgap of GaN is thereby 3.4 eV. The micro-electromechanical unit 100 further comprises a support structure 30. The support structure 30 supports the diaphragm 10. Preferably, an average cross-sectional area of the support structure 30 taken in the planar extension is smaller than an area of the diaphragm 10. The support structure 30 may elevate the diaphragm 10 from the plane of the substate 110. Hence, a bottom surface 12 of the diaphragm 10 and a top surface 112 of the plane of the substrate 110 may be separated by a diaphragm-substrate distance D1 being the closest distance between the diaphragm 10 and the substrate 110. A cavity 40 may thereby be present below the diaphragm 10. Hence, the diagram 100 may be allowed to vibrate and/or expand/contract in the vertical direction. The diaphragm 10 may be p doped to form a two-dimensional hole gas in the interface 23 between AI(1-x)Ga(x)N and GaN. This because of the slightly different lattice constant between AI(1-x)Ga(x)N and GaN, forming a potential well perpendicular to the interface 23 so small that only a small number of bound electron states may exist, thereby preventing electrons or holes moving perpendicular to the interface 23. Electrons or holes may, however, still move in vertical direction (e.g., across a superlattice of heterostructures) if a sufficient bias voltage across the interface 23 is applied.

The micro-electromechanical unit 100 further comprises an electrode 50 connected to the diaphragm. Preferably, the electrode 50 is arranged on a surface 14 of diaphragm 10. The electrode 50 may be directly attached on a top surface 50 of the diaphragm 10. The electrode 50 may be manufactured by any adequate electrically conducting material. For instance, the electrically conducting material may be Ti, Al, Cu, Ni, and/or Au. Preferably, the electrically conducting material is a compound or alloy such as, e.g. aluminium copper, AlCu.

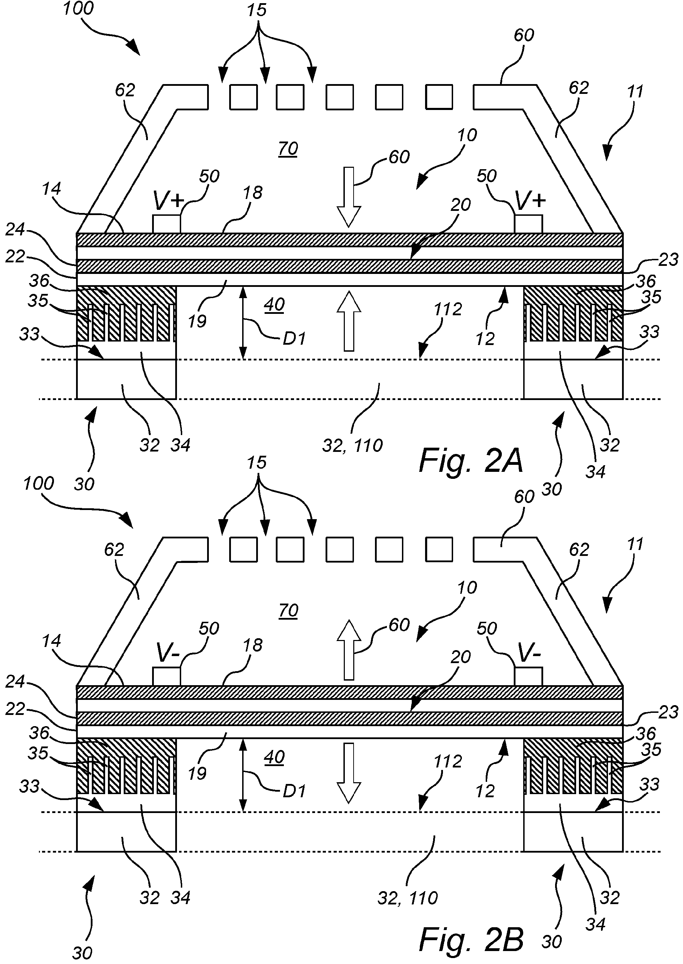

The semiconductor structure 20 of the diaphragm 10 has piezoelectrical properties. Hence, a mechanical deformation of the semiconductor structure of the diaphragm provide for electrically polarize the semiconductor structure. A non-zero voltage between different locations on the semiconductor structure may thereby be induced by the mechanical deformation 60, 62. This is schematically shown in Figs 2A and 2B. The non-zero voltage may further induce an electrical current. As is normal for piezoelectrical material, the opposite is possible. That is, a bias-voltage applied between different locations may generate a mechanical deformation of the semiconductor 20 structure of the diaphragm. In the present situation, this effect may be achieved by charging the electrode 50. The charging may generate a deformation 60, 62 of the diaphragm 10 such that the diaphragm 10 contracts 60 or expands 62 in the vertical direction, i.e. in a direction substantially perpendicular to the planar extension of the diaphragm 10. For instance, a positive bias-voltage applied on the electrode 50 may generate a contraction 60 of the diaphragm, whereas a negative bias-voltage applied on the electrode 50 may generate an expansion 62 of the diaphragm 10.

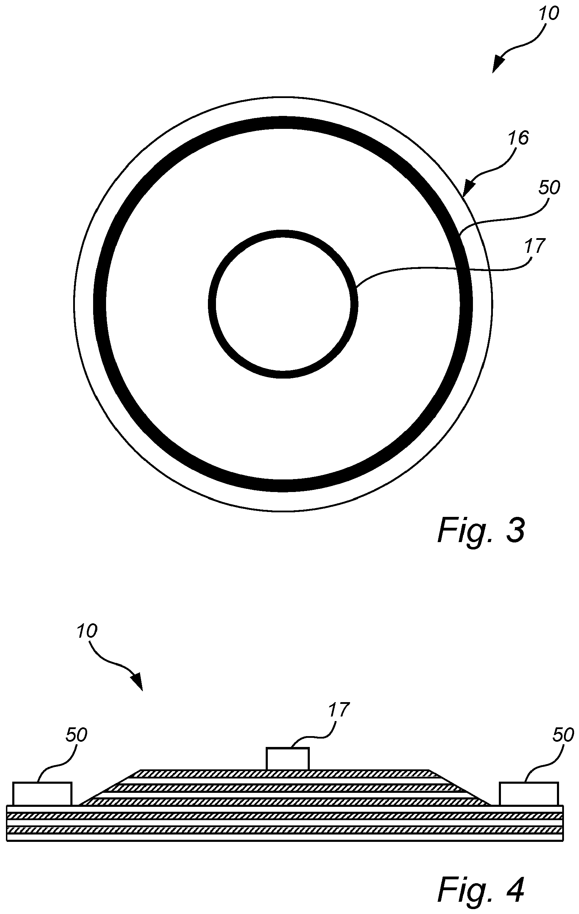

The diaphragm 10 may be circular in the planar extension. This is shown in Fig. 3. The geometry of the diaphragm may thereby be substantially circularly symmetric when seen from a direction perpendicular to the surface of the diaphragm 10. The support structure 30 may thereby have a similar circular geometry, for supporting the diaphragm 10 in proximity of the outer edge 16 of the diaphragm 10. Hence, the support structure 30 may be substantially circular cylindrical, the support structure 30 having an axial extension being perpendicular to the plane of the diaphragm (and the plane of the substrate). A thickness of a cylindrical wall of the support structure may be significantly smaller than a diameter of the diaphragm 10. The diameter of the diaphragm 10 may be between 1 and 50 µm.

In the event the diaphragm 10 has a circular geometry, the electrode 50 may be ring shaped and arranged at an edge of the diaphragm. The electrode 50 may be simply connected. Hence, any rupture or insulating portion along the azimuthal direction of the ring-shaped electrode 50 may be absent.

The semiconductor structure 20 of the diaphragm 10 may be a superlattice 20 comprising GaN and AI(1-x)Ga(x)N, wherein 0.2 ≤ x ≤ 0.4. This is schematically shown in Fig. 1. The superlattice 20 may comprise a plurality of heterostructure layers 22, 24, wherein each heterostructure layer comprises one GaN layer 22 and one AI(1-x)Ga(x)N layer 24. Hence, every second layer, 2i, may be a GaN layer 22, and every layer in between respective pair of layers of GaN, 2(i+1), may be a AI(1-x)Ga(x)N 24. However, the number of layers need not be an even number. Should the number of layers be an odd number, the bottom layer and the top layer may have a similar chemical composition; either GaN or AI(1-x)Ga(x)N. The periodicity of the superlattice 20 may be between 2 and 6 nanometers, nm. The superlattice 20 may provide a plurality of planes, wherein, in respective plane a p-type two-dimensional hole gas, 2DHG, is present. The 2DHG thereby provides a channel for conduction along an interface 23 between two adjacent layers 22, 24. However, as set out above, electrons or holes may move between layers provided a sufficient bias voltage is applied between layers. The superlattice 20 may be capable of generating an increased piezoelectrical effect.

A cross-sectional profile of the superlattice 20 taken in a plane coinciding with a center line of the semiconductor structure 20, i.e. parallel to the axial extension of the support structure 30, need not be rectangular, as exemplified in Fig. 4. Hence, a top layer 18 of the superlattice 20 may have a smaller area than a bottom layer 19 of the superlattice. By way of example, the superlattice 20 may be radially chamfered such that a circumferential edge portion of the diaphragm 10 has a thickness being smaller than a thickness of a center portion of the diaphragm. Preferably, the diaphragm 10 is chamfered such that a bottom surface and a top surface of the diaphragm 10 in vicinity of the circumferential edge are substantially parallel. On this top surface the electrode 50 may be attached. Likewise, a top surface and a bottom surface of a centered portion of the diaphragm may be substantially parallel. The center portion may be associated with an area of the diaphragm 10 being relatively large, such that, e.g. constituting half or more of an area of a total top surface 14 of the diaphragm 10.

A thickness of the superlattice 20 may be between 0.1 and 5 µm. Hence, the superlattice 20 may comprise hundreds or even thousands of AlGaN/GaN heterostructure layers 22,24. As set out above, the thickness may vary between, e.g. an edge portion 11 and a central portion 13 of the diaphragm 10. Preferably, the thickness is larger in the central portion 13 than in the edge portion 11. Further, the thickness may be radially dependent.

The micro-electromechanical unit may further comprise a backplate 60. The backplate may comprise a plurality of through holes 15. The backplate is elevated relative to the diaphragm by a circumferential wall 62. The circumferential wall 62 is directly or indirectly, preferably directly, attached to the diaphragm 10. Preferably, to a circumferent of the diaphragm 10. Alternatively, the circumferential wall 62 is attached to the support structure 30. Hence, a cavity 70 is present between the diaphragm 10 and the backplate 60. The cavity may be viewed as a pressure chamber or a resonant box. The through-holes 15 may be through-going openings oriented perpendicular to the planar extension of the backplate 10. The plurality of through-holes 15 may be randomly distributed in the backplate 10. Alternatively, the plurality of through-holes 15 may be orderly distributed such that the through-holes 15 themselves form a lattice when viewing the backplate 60 from a direction perpendicular to its top or bottom surface.

Now returning to the support structure 30 of the micro-electromechanical unit 100. The support structure 30 may comprise a semiconductor layer structure forming a transistor. As set out above, the layer structure may be understood as a layer being arranged above another layer in the vertical direction as well as the above layer sharing a physical interface with the below adjacent layer. Such a physical interface may be configured to provide conductive contact, i.e. allowing electron and/or hole transport across the physical interface. Conductive contact may refer to, e.g. ohmic contact, Schottky contact or contact across a pn-junction or tunnel junction. The transistor may be a high-electron-mobility transistor, HEMT, which may allow relatively high switching frequencies and desirable high-power characteristics. This since conduction electron/holes propagate in two dimensions (2DEG/2DHG) along an interface between two layers as set out above, facilitating high electron/hole mobility, and/or other typical properties of 2DEGs or 2DHGs. Notice that electron or hole mobility is generally smaller between layers in the layer structure than in the plane of the layers.

The semiconductor layer structure of the support structure 30 may comprise a silicon base layer 32. The silicon base layer 32 may be directly attached on the substrate 110. Alternatively, the silicon base layer 32 may form part of the substrate 110 in that the silicon base layer 32 is a relatively large silicon wafer on which AIN may be grown (further discussed below). The substrate 32, 110 may thereby comprise a silicon bulk material 32, 110. A top surface 33 of the silicon base layer 32 may be substantially planar. The vertical thickness of the silicon base layer may be in the range 100-1000 µm, and more preferably in the range 275-525 µm. If not explicitly stated otherwise, thickness will henceforth refer to vertical thickness. The top surface 33 of the silicon base layer may have Miller indices (111). The silicon base layer 32 may have a diamond-cubic crystal structure.

The semiconductor layer structure of the support structure may comprise an aluminium nitride, AIN, layer 34. The AIN layer 34 may preferably have a thickness in the range 100-500 nm and more preferably a thickness in the range 200-300 nm. The AIN layer may comprise vertical nanowire structures 35. These nanowires 35 may preferably have a vertical length in the range 50-500 nm and more preferably a vertical length in the range 150-250 nm. The vertical nanowire structures 35 may preferably have a substantially circular or hexagonal lateral cross section profile. A diameter of such a nanowire may be in the range 5-50 nm and more preferably 10-30 nm. The nanowires 35 may be arranged in a repeating array pattern seen in the vertical direction where each nanowire 35 has four equidistant closest other nanowires. Alternatively, the repeating array pattern may have a square pattern. A distance between adjacent nanowires 35 may preferably be in the range 10-500 nm, and more preferably in the range 50-200 nm.

The semiconductor layer structure of the support structure 30 may further comprise a GaN layer 36 and a AI(1-x)Ga(x)N layer (not shown), wherein 0.2 ≤ x ≤ 0.4. The AI(1-x)Ga(x)N layer may be situated between the GaN layer 36 and the diaphragm 10. The layer arranged directly above the previously described AIN layer 34 may be the GaN layer 36. The GaN layer 36 may preferably have a thickness in the range 100-500 nm and more preferably a thickness in the range 200-300 nm. The GaN layer 36 may be considered to laterally enclose, encapsulate, or encompass the vertical nanowire structures 35, i.e. filling in the space between the vertical nanowire structures. The GaN layer 36 may further be considered to vertically enclose or encapsulate the vertical nanowire structures, i.e. extending vertically above and covering top portions of the vertical nanowire structures.

The GaN layer 36 may attach directly to the diaphragm 10.

The micro-electromechanical unit 100 may further comprise a calibrating weight 17 arranged on a surface of the diaphragm 10. The calibrating weight 17 may be directly situated on the top surface of the diaphragm. In the event the diaphragm is circular, as exemplified above, the calibrating weight 17 may be ring-shaped. This particular example shape is shown in Fig. 3. The calibrating weight 17 may be centrally located on the diaphragm. Hence, the centre of the diaphragm 10 and a centre of the ring-shaped calibrating weight 17 may substantially coincide. The calibrating weight 17 may be manufactured by a metallic compound or alloy such as, e.g. AlCu. Other materials may however be applicable.

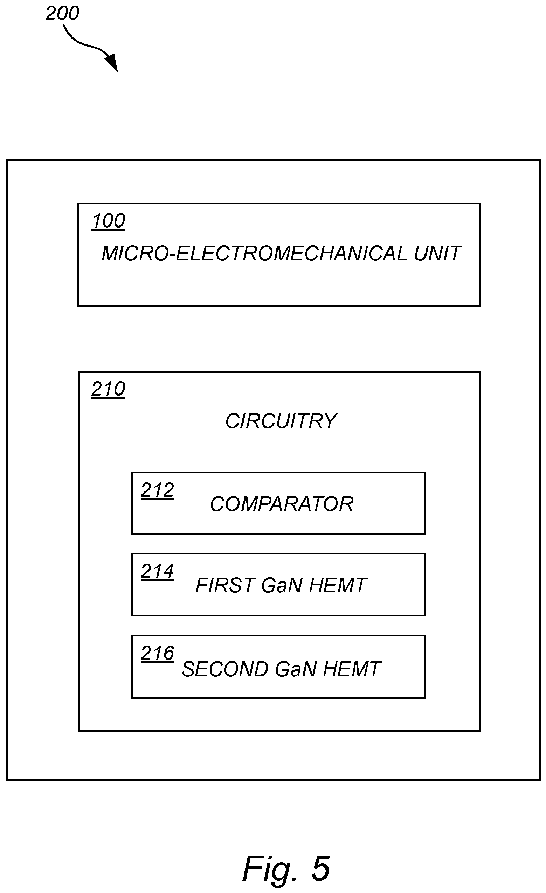

In connection with Fig. 5, a loudspeaker device 200 is schematically shown. The loudspeaker device 200 comprises a micro-electromechanical unit. The micro-electromechanical unit 100 is as described above. The loudspeaker device 200 further comprises circuitry 210 configured to actuate the diaphragm 10 of the micro-electromechanical unit 100. The circuitry 210 may form part of a class D audio amplifier. Hence, the circuitry 210 may utilize pulse-width modulation, PWM, using a triangle- or a square wave oscillator. Traditional class D amplifiers comprise two output MOSFETs and an external lowpass filter to recover the amplified audio signal. However, herein the class D amplifier may be a filter-less amplifier. Further, a first and a second GaN high electron mobility transistor, HEMT, may replace the traditional MOSFETs. The HEMTs may operate as current steering switches by alternately connecting an output node to a supply voltage, Vdd, and ground. Hence, the resulting output is a high-frequency square wave. The output square wave may be pulse-width modulated by the input audio signal. This may be achieved by comparing the input audio signal to an internally generated triangle- or sawtooth wave oscillator. This may be referred to a natural sampling where the triangle wave oscillator may act as a sampling clock. The resulting duty cycle of the square wave is proportional to the level of the input signal. The GaN HEMTs may be arranged for a variable such a duty cycle. The diaphragm 10 of the micro-electromechanical unit 100 may function as a source for sound waves of the loudspeaker device 200. Acoustical properties of the diaphragm 10 thereby depend on the semiconductor structures thereof, e.g. the number of layers in semiconductor structure of the diaphragm 10, possible through-holes 15, geometry in the planar extension, etc. The acoustical properties to be configured herein may, as traditionally, include relative intensity, vibrational frequency, or the like. The class D amplifier may be a full bridge class D amplifier. The circuitry 210 may comprise a comparator 212. The comparator 212 may function as an ordinary comparator, e.g. an operational amplifier, by comparing an audio input signal to a high-frequency triangle wave to digitize the audio input signal. The result of the comparison is a digital copy signal from the analogue audio input signal, wherein low-frequency components of the digital signal represent the audio input signal, while high-frequency signals are in general ignored. The first and the second HEMT may be electrically connected to the comparator. The output of the comparator drives the HEMT by an intermediately connected driver as is normal for, e.g. a class D amplifier. The diaphragm 10 may in connection with the loudspeaker device 200 be an 8-ohm speaker. The circuitry 210 may comprise a field-programmable gate array, FPGA, to handle the digital part of the device. The input audio may be a 24-bit pulse-code modulated, PCM, signal with a kHz sample rate to be encoded into streams of pulses.

The driving of GaN HEMT devices requires care to be taken to the distances between the GaN HEMT devices gate contact and the driver. The GaN HEMT devices may be abutting the driver to provide a short and equal distance between several GaN HEMT devices in order to switch the GaN HEMT devices ON and OFF in an alternating fashion for a half-bridge or full-bridge operating at a high switching frequency.

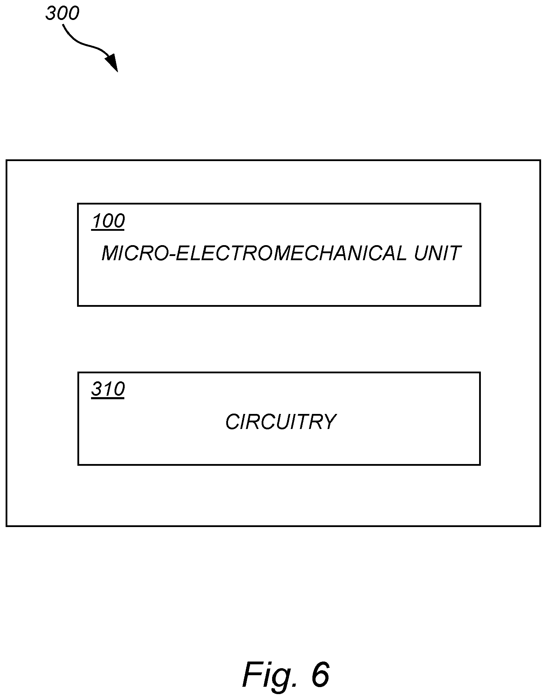

In connection with Fig. 6, there is schematically shown a microphone device 300. The microphone device 300 comprises a micro-electromechanical unit 100. The micro-electromechanical unit 100 is as described above. The micro-electromechanical unit 100 comprises circuitry 310. The circuitry 310 is configured to detect a movement of the diaphragm 10 of the micro-electromechanical unit 100. Hence, a mechanical movement of the diaphragm 10 induces a voltage difference which can be converted to electrical signals "backwards" in view of the features described in connection to the loudspeaker device above.

Accordingly, and in summary, as discussed above, there has been described a micro-electromechanical unit 100. The micro-electromechanical unit 100 may e.g. be used in a loudspeaker or a microphone. The piezoelectrical properties of the diaphragm 10 of the micro-electromechanical unit 100 may turn a coil/solenoid redundant as an applied bias voltage may, by the diaphragm itself, be converted to a mechanical movement/deformation 60, 62, and vice versa.

The person skilled in the art realizes that the present invention by no means is limited to the preferred embodiments described above. On the contrary, many modifications and variations are possible within the scope of the appended claims.

For example, it is readily understood that the micro-electromechanical unit may be used in many different devices, such as pressure sensors, flow sensors, and cantilever-based sensors for biomarkers.

Variations to the disclosed embodiments can be understood and effected by the skilled person in practicing the claimed invention, from a study of the drawings, the disclosure, and the appended claims.

## Claims

1. A micro-electromechanical unit (100) comprising:
a diaphragm (10) having a planar extension, the diaphragm (10) comprising a semiconductor structure (20) comprising a first (24) and a second (24) layer, each layer extending in the planar extension, wherein the first layer (22) comprises Al(1-x)Ga(x)N, wherein 0.2 ≤ x ≤ 0.4, and the second layer (24) comprises GaN:
a support structure (30) supporting the diaphragm (10); and
an electrode (50) connected to the diaphragm.

2. The micro-electromechanical unit (100) according to claim 1, wherein the diaphragm (10) is circular in the planar extension, wherein a diameter of the diaphragm (10) is between 1 and 50 micrometer.

3. The micro-electromechanical unit (100) according to claims 1 or 2, wherein the semiconductor structure (20) of the diaphragm (10) is a superlattice (20) comprising GaN (22) and Al(1-x)Ga(x)N (24) layers, wherein 0.2 ≤ x ≤ 0.4.

4. The micro-electromechanical unit (100) according to claim 3, wherein a periodicity of the superlattice (20) is between 2 and 6 nm.

5. The micro-electromechanical unit (100) according to any one of claims 1-4, wherein a thickness of the diaphragm (10) is between 0.1 and 5 µm.

6. The micro-electromechanical unit (100) according to any one of claims 1-5, further comprising a backplate having a plurality of through-holes (15).

7. The micro-electromechanical unit (100) according to any one of claims 1-6, wherein the electrode (50) is ring shaped and arranged at an edge of the diaphragm (10).

8. The micro-electromechanical unit (100) according to any one of claims 1-7, wherein the support structure (30) comprises a semiconductor layer structure forming a transistor.

9. The micro-electromechanical unit (100) according to claim 8, wherein the semiconductor layer structure of the support structure (30) comprises a silicon base layer (30,110).

10. The micro-electromechanical unit (100) according to claim 8 or 9, wherein the semiconductor layer structure of the support structure (30) comprises a GaN layer (36) and a Al(1-x)Ga(x)N layer, wherein 0.2 ≤ x ≤ 0.4.

11. The micro-electromechanical unit (100) according to any one of claims 8-10, wherein the semiconductor layer structure of the support structure (30) comprises a AlN layer (34).

12. The micro-electromechanical unit (100) according to any one of claims 1-11, further comprising a calibrating weight (17) arranged on a surface of the diaphragm (10).

13. A loudspeaker device (200) comprising:
a micro-electromechanical unit (100) according to any one of claims 1-12; and
circuitry (210) configured to actuate the diaphragm (10) of the micro-electromechanical unit (100).

14. The loudspeaker device (200) according to claim 13, wherein the circuitry (210) comprises:
a driver;
a comparator (212); and
a first (214) and a second (216) GaN high electron mobility transistor, HEMT, abutting the driver;
wherein the first (214) and the second (216) HEMT are electrically connected to the comparator (212).

15. A microphone device (300) comprising a micro-electromechanical unit (100) according to any one of claims 1-12 and circuitry (310) configured to detect a movement of the diaphragm (10) of the micro-electromechanical unit (100).
